# FASCICULE DE BREVET EUROPEEN

(11) **EP 4 044 776 B1**
(45) Date de publication et mention de la délivrance du brevet: **10.07.2024**
(21) Numéro de dépôt: 22150569.6
(22) Date de dépôt: 07.01.2022
(51) Int. Cl.: H05K 7/14

(54) **VENTILATEUR MÉDICAL À CARTE ÉLECTRONIQUE MONTÉE PIVOTANTE**
MEDIZINISCHES BEATMUNGSGERÄT MIT SCHWENKBAR MONTIERTER ELEKTRONIKKARTE
MEDICAL FAN WITH PIVOTABLY MOUNTED ELECTRONIC CARD

(30) Priorité: 16.02.2021 FR 2101450
(43) Date de publication de la demande: 17.08.2022
(73) Titulaire: Air Liquide Medical Systems, 92182 Antony Cedex (FR)
(72) Inventeur: LOPEZ, Julien, 92182 Antony Cedex (FR); RUDNIANYN, Philippe, 92182 Antony Cedex (FR); KAHALE, Christian, 92182 Antony Cedex (FR)
(74) Mandataire: Air Liquide

(56) Documents cités:
- WO-A1-2017/006189
- WO-A1-2018/199774
- CN-A- 109 395 216
- JP-A- 2008 147 784
- US-A1- 2008 234 577
- US-A1- 2011 203 587

## Description

L'invention concerne un ventilateur médical équipé d'une carte électronique montée pivotante dans le ventilateur afin notamment de faciliter son montage, son câblage et sa maintenance.

Un ventilateur médical est un appareil d'assistance respiratoire servant à délivrer une aide respiratoire, c'est-à-dire une ventilation artificielle, à un patient souffrant de troubles ou insuffisances respiratoires, plus ou moins sévères, pouvant résulter de différentes pathologies ou analogues. Certains patients ayant des pathologies sévères peuvent rester ventilés en milieu hospitalier, pendant plusieurs jours, même plusieurs mois.

Pendant son fonctionnement, le ventilateur médical délivre un gaz respiratoire au patient, par exemple de l'air ou de l'air enrichi en oxygène, et opère un suivi, i.e. monitorage, de paramètres ventilatoires (e.g. pression du gaz, pression oesophagienne, volumes de gaz échangés, débit de gaz...). Le gaz respiratoire peut être délivré par une soufflante motorisée, aussi appelée turbine ou compresseur.

Par ailleurs, les paramètres ventilatoires sont généralement affichés sur un écran d'affichage d'une interface graphique utilisateur (IGU), aussi appelée interface homme-machine (IHM), du ventilateur médical sous forme de courbes, de données, d'informations, d'icônes ou autres... L'IHM comprend en outre des moyens de sélection ou de réglages, telles des touches tactiles, permettant au personnel soignant d'opérer des sélections, des réglages ou autres.

Le fonctionnement du ventilateur, en particulier celui de la micro-soufflante motorisée, les affichages sur l'écran d'affichage de l'IHM... sont contrôlés et pilotés par des moyens de pilotage, typiquement une (ou des) carte électronique à microprocesseur(s) agencée dans la carcasse du ventilateur.

Plus précisément, une carte électronique est souvent montée de manière fixe et à plat dans les ventilateurs. Or, en pratique, un tel montage peut engendrer des contraintes de conception des ventilateurs car il oblige à créer un compartiment dédié à toute l'électronique du ventilateur, en particulier à la ou aux cartes électroniques. Un exemple d'un tel ventilateur est donné par WO-A-2017/006189.

Ceci complique aussi, lors de la fabrication du ventilateur, le câblage des faisceaux de câbles reliant la (ou les) carte électronique aux différents composants du ventilateur auxquels elle (ou elles) doit être reliée, comme l'IHM, l'écran, la source de courant d'alimentation électrique, la soufflante motorisée..., ainsi que la maintenance de cette (ou ces) carte électronique lors des opérations de maintenance.

Plus précisément, il est fréquent de trouver les connecteurs ou embases de connexion des faisceaux de s sur les deux faces opposées d'une même carte électronique.

Or, ceci ne favorise pas les manipulations de la carte, lors de son câblage. En effet, plus la carte est touchée et manipulée, plus il y a de risque de détériorer un composant.

De plus, lorsque des embases de connexion se trouvent sur les deux faces d'une même carte électronique, celles-ci ne sont pas facilement contrôlables visuellement. En effet, une fois câblée, il est difficile de retourner une carte pour s'assurer que les connexions sont correctes, du fait des tensions de câbles.

Enfin, une fois totalement câblée, la carte doit être fixée fermement sur un support dans la carcasse du ventilateur. Ceci peut être compliqué car l'opérateur doit maintenir la carte d'une main et de l'autre main réussir à insérer les vis de fixation dans leurs emplacements, puis à les visser. Cette opération est particulièrement périlleuse quand la carte est agencée à la verticale ou inclinée car cela engendre un risque supplémentaire de dégradation des composants.

Le problème est donc de faciliter le montage, le câblage et la maintenance de la (ou des) carte électronique dans un ventilateur médical sans rencontrer tout ou partie des inconvénients ou problèmes pratiques susmentionnés.

La solution de l'invention concerne alors un ventilateur médical, c'est-à-dire un appareil d'assistance respiratoire, comprenant une carcasse externe et des moyens de pilotage comprenant au moins une carte électronique, la carcasse comprenant une embase et un capot fixé de manière détachable à l'embase, ledit capot pouvant être retiré pour donner accès à l'intérieur du ventilateur, caractérisée en ce que :
- il comprend en outre un écran d'affichage porté par un bras-support surmontant la carcasse du ventilateur, et
- ladite carte électronique est montée pivotante (axe AA) sur une structure-support agencée à l'intérieur de la carcasse externe du ventilateur.

Selon le mode de réalisation considéré, le ventilateur médical de l'invention peut comprendre l'une ou plusieurs des caractéristiques suivantes :
- l'angle de pivotement de la carte électronique est inférieur à 150°, en général inférieur à 120°, typiquement compris entre 20° et 90°, de préférence d'au moins 30°, voire d'au moins 40°.
- ladite au moins une carte électronique est agencée en position verticale ou quasi-verticale dans le ventilateur, lorsqu'elle est en position non-pivotée et fixée (i.e. solidarisée) à la structure-support.
- la structure-support comprend un châssis.
- le châssis est métallique ou en polymère, de préférence métallique, avantageusement en alliage d'aluminium.
- le ventilateur comprend une carcasse ou coque externe rigide, par exemple en polymère.
- la structure-support est agencée dans la carcasse du ventilateur et supporte ladite carcasse du ventilateur.
- le châssis est situé dans la carcasse du ventilateur.
- le châssis porte tout ou partie de la carcasse externe du ventilateur.
- le châssis et l'embase sont solidarisés l'un à l'autre.
- la carte électronique comprend un ou plusieurs microprocesseurs.
- la carte électronique est maintenue immobile par des moyens de maintien, de préférence des moyens de maintien par vissage.
- les moyens de maintien par vissage comprennent une ou plusieurs vis ou analogue destinées à venir se visser dans un ou des logements taraudés agencés dans la structure-support, typiquement le châssis, par exemple un ou des bras de maintien faisant partie du châssis, notamment deux bras de maintien agencés en parallèle.
- la carte électronique comprend une ou plusieurs expansions ou pattes de fixation comprenant chacune un orifice la traversant.
- la carte électronique a une forme rectangulaire ou carrée.
- des expansions ou pattes de fixation sont situées au niveau de tout ou partie des angles de la carte électronique de forme rectangulaire ou carrée.
- il comprend en outre une soufflante motorisée pour fournir un gaz respiratoire, tel de l'air, de l'oxygène ou de l'air enrichi en oxygène.
- il comprend en outre un circuit de gaz relié fluidiquement à la soufflante de manière à acheminer le gaz fourni par ladite soufflante.
- le circuit de gaz comprend un ou des conduits, passages ou analogues pour le gaz, et de préférence une ou des vannes, notamment des électrovannes.
- la soufflante motorisée est portée par le châssis.
- la soufflante motorisée comprend un moteur électrique.
- il comprend en outre un écran d'affichage pour afficher des informations, des courbes, des touches de sélection ou de réglage, des icônes ou autres, de préférence un écran tactile.
- il comprend en outre une interface homme-machine (IHM), de préférence l'IHM comprend l'écran d'affichage.
- l'IHM comprend en outre un ou plusieurs boutons ou touches de réglage ou sélection actionnable par l'utilisateur.
- l'écran d'affichage est tactile, de préférence il comprend une ou des touches tactiles s'affichant sur l'écran d'affichage.
- Il comprend une ou des poignées de manipulation permettant à un utilisateur de manipuler et orienter facilement l'écran d'affichage.
- il comprend deux poignées agencées de part et d'autre de l'écran, c'est-à-dire le long des côtés droit et gauche de l'écran d'affichage.
- l'écran d'affichage est protégé par un carter protecteur, c'est-à-dire qu'une enveloppe protectrice rigide est agencée autour de l'écran d'affichage.
- le carter protecteur est agencé autour de l'écran, c'est-à-dire le long des bords périphériques de l'écran et en regard de sa partie ou face arrière.
- le carter protecteur de l'écran délimite ou comprend un volume ou compartiment interne contenant les éléments ou composants électroniques servant à faire fonctionner l'écran d'affichage, tels qu'au moins une seconde carte électronique, un codeur rotatif, un indicateur de type LED de mise sous tension, des connexions ou autres.
- le carter protecteur délimite ou comprend un volume interne situé à l'arrière de l'écran d'affichage.
- l'écran d'affichage et le carter protecteur forment une structure tridimensionnelle plate.
- les deux poignées latérales sont fixées à, i.e. ou solidaires du carter protecteur de l'écran d'affichage.
- le carter protecteur de l'écran est en polymère rigide.
- les deux poignées latérales sont en forme d'arceaux, de préférence des arceaux ayant une forme de bande.
- les deux poignées latérales et/ou le carter protecteur sont en polymère rigide
- le polymère est par exemple un ABS/PC.
- le système d'orientation est configuré pour permettre d'orienter l'ensemble formé par l'écran d'affichage équipé de son carter protecteur.
- le bras-support portant l'écran d'affichage est fixé au châssis.
- l'écran d'affichage est orientable selon plusieurs axes par rapport au bras-support, de préférence au moins 2 axes perpendiculaires (X, Y).
- les moyens de pilotage sont configurés pour piloter la soufflante, en particulier le moteur électrique, et/ou pour commander l'affichage sur l'écran.
- il comprend en outre des moyens d'alimentation en courant électrique.
- les moyens d'alimentation en courant électrique sont raccordés électriquement (directement ou indirectement) à la carte électronique, à l'écran d'affichage, à la soufflante et plus généralement à tous les éléments ou composants du ventilateur requérant du courant électrique pour fonctionner.
- la (au moins une) carte électronique du ventilateur est configurée pour piloter la soufflante motorisée et/ou pour contrôler l'affichage sur l'écran d'affichage.
- le châssis porte en outre un ou plusieurs ventilateurs de refroidissement servant à faire circuler de l'air dans la carcasse afin de refroidir la ou les cartes électroniques, voire d'autres composants internes du ventilateur, comme le moteur de la turbine ou encore des blocs échangeurs thermiques favorisant les échanges thermiques de manière à ce que le gaz envoyé au patient ne soit pas trop chaud, par exemple qu'il n'excède pas 70°C sur une plage de 120 secondes ou une énergie équivalente dans des conditions d'environ 43°C à 100% d'humidité, soit une enthalpie spécifique de 197 kj/m³ quelle que soit la plage de ventilation choisie.
- le châssis porte en outre au moins une partie du circuit de gaz (i.e. conduits, vannes...).
- le châssis porte en outre le bras-support faisant office de mât portant l'écran.
- le châssis porte en outre une carte d'alimentation électronique servant à convertir la tension du secteur (110/220V) en une tension d'alimentation adéquate compatible avec les composants électroniques et autres du ventilateur.
- le châssis porte en outre une batterie d'alimentation électrique rechargeable.
- les moyens de pilotage sont configurés pour commander la soufflante de manière à délivrer du gaz au moins pendant les phases inspiratoires du patient.
- les moyens de pilotage sont configurés pour piloter les accélérations et les freinages/ralentissements du moteur électrique de la soufflante.
- l'écran d'affichage comprend une ou des touches tactiles permettant d'opérer des sélections, des validations, des réglages, des démarrages ou des arrêts de fonctionnement... Les touches tactiles sont à actionnement digital, c'est-à-dire qu'elles sont activées lorsque l'utilisateur appuie dessus avec son doigt, typiquement son index.
- l'écran d'affichage est configuré pour opérer un affichage d'informations sous forme de caractères alphanumériques, de représentations graphiques (e.g. graphes, courbes, dessins, icones, etc....), de photos, d'animations vidéo...... ou autres.
- la soufflante comprend un moteur électrique, c'est-à-dire fonctionnant grâce à un courant électrique.
- la soufflante comprend un moteur électrique entraînant une roue à ailettes agencée dans le compartiment interne d'une volute.
- la soufflante est commandée pour atteindre une vitesse de rotation maximale de 25 000 tours/minute, typiquement entre 500 et 15 000 tr/min, par exemple de l'ordre de 9 500 tr/min maximum.

L'invention va maintenant être mieux comprise grâce à la description détaillée suivante, faite à titre illustratif mais non limitatif, en référence aux figures annexées parmi lesquelles :
Fig. 1 représente une carte électronique pivotante selon l'invention, montrée en position fixée (i.e. non-pivotée) dans un ventilateur médical selon l'invention.
Fig. 2 représente la carte électronique de Fig. 1, montrée en position pivotée.
Fig. 3 est une vue sous un autre angle de la carte électronique de Fig. 2.
Fig. 4 représente les moyens de maintien permettant de maintenir la carte électronique en position non-pivotée, comme sur Fig. 1 et Fig. 6.
Fig. 5 est une vue générale d'un mode de réalisation d'un ventilateur médical selon l'invention.
Fig. 6 est une représentation (par transparence) de l'intérieur du ventilateur de Fig. 5 montrant la carte électronique dans sa position fixée de Fig. 1.
Fig. 7 est représentation (haut de carcasse enlevé) de l'intérieur du ventilateur de Fig. 5 montrant la carte électronique dans sa position pivotée de Fig. 2.
Fig. 8 est représentation sous un autre angle de l'intérieur du ventilateur de Fig. 5.
Fig. 9 est représentation sous un autre angle de l'intérieur du ventilateur de Fig. 5 faisant mieux apparaitre l'architecture du châssis portant le bras-support.

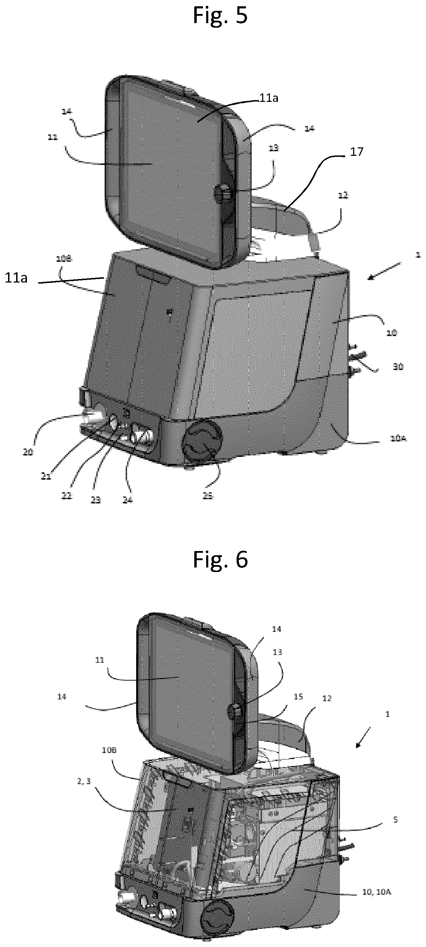

Fig. 5 à Fig. 7 schématise un mode de réalisation d'un ventilateur médical 1, c'est-à-dire un appareil d'assistance respiratoire, délivrant une ventilation assistée à un patient selon l'invention. Il est conçu pour fournir un gaz respiratoire à un patient, à savoir un gaz médical, par exemple de l'air provenant de l'atmosphère ambiante, de l'oxygène pur provenant d'une source d'oxygène, par exemple une bouteille d'oxygène médical ou d'une canalisation véhiculant de l'oxygène médical au sein d'un bâtiment hospitalier, ou encore de l'air enrichi en oxygène.

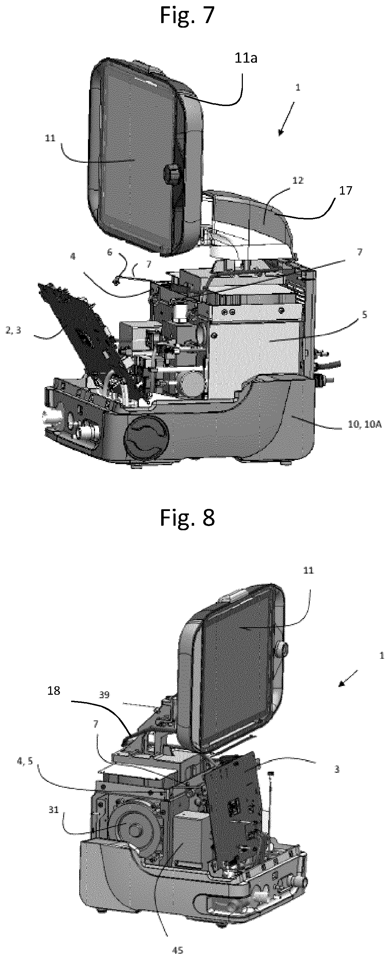

Le ventilateur médical 1 comprend une carcasse ou coque externe 10 rigide, par exemple en polymère, dans laquelle sont agencés les différents éléments permettant son fonctionnement, en particulier une soufflante 31 motorisée (cf. Fig. 7), d'environ 20 cm de diamètre, aussi appelée turbine ou compresseur, délivrant le gaz respiratoire (e.g. air, un mélange air/O₂, oxygène pur...), un circuit de gaz interne (i.e. conduits ou passages de gaz, vannes...) pour véhiculer les flux gazeux dans le ventilateur 1, des moyens de pilotage 2 à microprocesseur(s), une (ou des) batterie ou analogue rechargeable...

Lorsqu'un mélange air/O₂ est désiré, il peut être réalisé dans un mélangeur de gaz interne du ventilateur 1, aussi appelé bloc mélangeur, visible en Fig. 8, comprenant des entrées ou admissions d'air et d'O₂ (à la pression désirée) et une sortie ou refoulement du mélange gazeux air/O₂ ainsi obtenu.

Dans ce mode de réalisation, la carcasse 10 est formée de deux sous-unités (ou plus) venant se solidariser l'une à l'autre, à savoir une embase 10A formant la partie basse ou inférieure de la carcasse 10 et un capot 10B formant la partie haute ou supérieure de la carcasse 10. Comme illustré en Fig. 7, le capot 10B est amovible, c'est-à-dire peut être retiré pour donner accès à l'intérieur du ventilateur 1, notamment lors de son assemblage (i.e. fabrication) ou lors de sa maintenance (i.e. entretien).

En fonctionnement, l'air ambiant est aspiré par la soufflante ou turbine 31, i.e. le compresseur ou ventilateur, motorisée via un port d'entrée en communication fluidique avec l'atmosphère ambiante. De préférence, l'air est filtré avant de pénétrer dans la soufflante.

La soufflante motorisée a une architecture classique. Elle comprend une (ou des) roue à ailettes entrainée en rotation par l'axe ou arbre rotatif d'un moteur électrique. La roue à ailettes est agencée, mobile en rotation, au sein d'un compartiment à roue agencé dans une volute, de préférence prise en sandwich entre une demi-volte inférieure et une demi-volte supérieure fixée de manière étanche l'une à l'autre. La volute comprend une entrée pour l'air provenant du port d'entrée d'air, c'est-à-dire l'air aspiré par la roue à ailettes, lors de ses rotations. Par ailleurs, la volute de la soufflante comprend un conduit de sortie de gaz par lequel le débit de gaz est expulsé hors de la volute, pendant les rotations de la roue à ailettes, et acheminé jusqu'au patient, via un conduit de gaz flexible débouchant au niveau d'une interface respiratoire patient, tel un masque respiratoire ou une sonde trachéale. Le conduit flexible vient se raccorder fluidiquement de manière détachable, au ventilateur 1.

Selon un mode de réalisation, le fonctionnement de la soufflante 32, en particulier les accélérations ou décélérations/freinages du moteur, est commandé par des moyens de pilotage 2, aussi appelés unité de commande électronique, typiquement une (ou des) carte électronique 3 à microprocesseur(s), de manière à fournir le gaz respiratoire aux débit et pression désirés, de préférence sélectionnés ou réglés par l'utilisateur via l'IHM, comme expliqué ci-après.

Selon un autre mode de réalisation, la vitesse du moteur n'est pas commandée pour atteindre le débit gazeux nécessaire. Ce sont des électrovannes qui sont impliqués dans la régulation et qui définissent les volumes et les pressions désirés. Dans ce cas, seules deux vitesses de turbine sont mises en oeuvre.

Par ailleurs, le ventilateur 1 peut comprendre en outre d'autres éléments, en particulier un (ou des) capteur de pression ou un (ou des) capteur de débit (e.g. capteur de débit massique et/ou à fil chaud) pour mesurer la pression du gaz et/ou le débit du flux gazeux dans le circuit de gaz interne, typiquement en aval de la soufflante. Les mesures (i.e. signaux) de pression et de débit sont transmises par les capteurs aux moyens de pilotage 2 du ventilateur 1.

Les moyens de pilotage 2 comprennent un ou plusieurs microprocesseurs agencés sur la (ou des) carte électronique 3, avantageusement un microcontrôleur, mettant en oeuvre un ou des algorithmes, permettant de monitorer et réguler la ventilation délivrée au patient en exploitant notamment les signaux de pression et de débit mesurés par les capteurs de pression et/ou de débit.

La (ou les) carte électronique 3 peut aussi comprendre des moyens de mémorisation pour mémoriser notamment les valeurs de pression et/ou de débit, par exemple une mémoire type flash ou autre portée par la carte électronique, ou dans tout autre moyen de mémorisation, y compris dans un algorithme du microprocesseur.

Par ailleurs, le ventilateur 1 comprend aussi une interface homme-machine ou IHM servant d'interface de réglage ou de sélection pour l'utilisateur, i.e. le personnel soignant.

Comme illustré sur les Fig. 5 à Fig. 7, l'IHM comprend ici un écran d'affichage 11 surmontant la carcasse 10 du ventilateur 1.

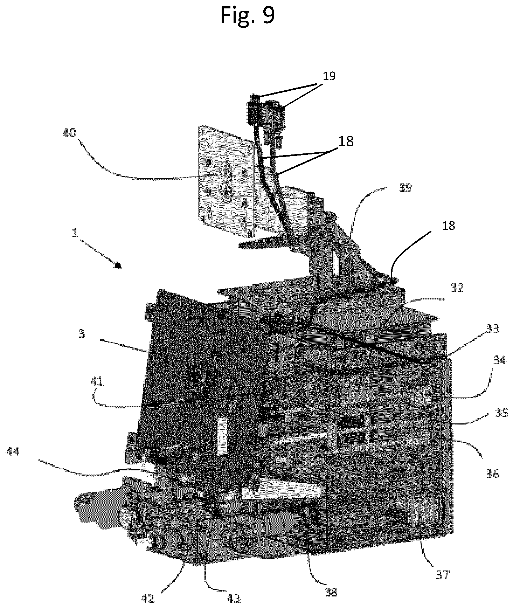

Dans le mode de réalisation présenté, l'écran d'affichage 11 est porté par un bras-support 12 comprenant un mât interne 39 et un système d'orientation de l'écran 40 orientable selon plusieurs axes par rapport au mât interne 39 du bras-support 12, de préférence au moins 2 axes perpendiculaires (X, Y), par exemple via un système à rotule ou une platine à 2 axes (par exemple de type VESA) ou analogue, illustrée en Fig. 9. L'orientation et les manipulations de l'écran 11 se font via deux poignées latérales 14 (e.g. ici en arceaux), agencées de part et d'autre de l'écran 11.

Par ailleurs, l'écran d'affichage 11 est protégé par un carter protecteur 11a constituant une enveloppe protectrice rigide agencée autour de l'écran d'affichage, c'est-à-dire le long des bords périphériques de l'écran 11 et en regard de sa partie ou face arrière. Le carter protecteur 11a délimite un volume interne contenant les éléments ou composants électroniques servant à faire fonctionner l'écran d'affichage, tels que carte électronique, codeur rotatif, indicateur LED de mise sous tension, connexions ou autres. L'écran d'affichage 11 et son carter protecteur 11a forment une structure tridimensionnelle plate.

De préférence, les deux poignées latérales 14 sont fixées au carter protecteur 11a. Le carter protecteur 11a et les deux poignées latérales 14 sont avantageusement en polymère rigide, par exemple en ABS/PC. Bien entendu, les poignées pourraient avoir une autre forme ou être en nombre supérieur à 2.

L'écran d'affichage 11 est préférentiellement un écran tactile, et de préférence en couleurs, sur lequel s'affichent, pendant son fonctionnement, sur des touches virtuelles de sélection ou de réglage actionnables par action digitale d'un utilisateur, c'est-à-dire lorsque l'utilisateur appuie dessus avec son index par exemple.

Les touches virtuelles peuvent se présenter sous forme d'icônes ou analogues. Elles permettent à un utilisateur d'opérer des choix et/ou des réglages, par exemple des niveaux de pression souhaités ou d'autres paramètres ventilatoires, d'activer et de désactiver des options de ventilation 1, ou des alarmes.

On voit que l'IHM comprend aussi ici un (ou des) bouton 13 rotatif qui sert à faire varier les valeurs à régler et à valider volontairement les configurations choisies. Il est agencé à côté de l'écran 11, c'est-à-dire dire sur le cadre 15 rigide entourant l'écran 11. Bien entendu, on peut prévoir aussi d'autres moyens de réglage/sélection comme par exemple des touches, curseurs ou analogues.

L'écran 11 est relié électriquement aux moyens de pilotage 2 de sorte que ces derniers puissent commander/piloter les affichages se faisant sur l'écran 11.

Le bras-support 12 est fixé à une structure-support 4, typiquement un châssis 5, située à l'intérieur du ventilateur 1, par exemple par vissage, comme détaillé ci-après.

Le bras-support 12 est protégé par une coque de protection périphérique 17 formant un manchon autour du mât interne 39 du bras-porteur 12. Cette coque de protection périphérique 12 est fixée audit mât interne 39 et s'étend sensiblement entre la carcasse externe 10 du ventilateur 1, en particulier le haut du capot amovible 10B, et le système d'orientation 40. La coque de protection 17 est avantageusement formée de plusieurs sous-unités ou parties fixées les unes aux autres, par exemple deux demi-coques venant se coupler l'une à l'autre en prenant en sandwich la structure métallique formant le mât interne 39 du bras-support 12. Elles sont démontables indépendamment du reste, notamment de la carcasse. La coque de protection périphérique 17 est en polymère ou tout autre matériau adapté.

La coque de protection périphérique 17 est en outre traversée par des câbles de liaison 18, notamment électrique ou autres, qui sont agencés le long du bras-support ou bras-porteur 12, comme illustré sur Fig. 8 et Fig. 9. Ces câbles de liaison 18 relient notamment les moyens de pilotage 2 et les moyens d'alimentation électrique à l'écran 11 afin de l'alimenter en courant et de piloter les affichages qui s'opèrent sur ledit écran 11, tel un écran numérique tactile 11.

Préférentiellement, les câbles de liaison 18 sont fixés au bras- support 12 afin d'être maintenus dans la coque de protection périphérique 12, par exemple au moyen de collier de serrage en métal ou plastique. Les câbles de liaison 18 sont munis de connecteurs 19 de raccordement pour permettre leur connexion électrique et raccordement mécanique à l'écran 11, comme illustré en Fig. 9, en particulier à ses composants internes assurant son bon fonctionnement.

Une source de courant électrique 37, par exemple une batterie rechargeable intégrée au ventilateur médical 1, un ou des câbles 30 avec prise de raccordement au secteur (110/220V), ou les deux, et préférentiellement une carte d'alimentation 32 faisant office de convertisseur de courant/tension, permet d'alimenter en énergie électrique, les composants du ventilateur 1 en ayant besoin pour fonctionner, en particulier la soufflante, les moyens de pilotage 2, notamment la carte(s) électronique(s) 3 et le(s) microprocesseur(s) porté par la carte 3, les capteurs de pression et/ou de débit, l'écran d'affichage 11, et/ou d'autres composants.

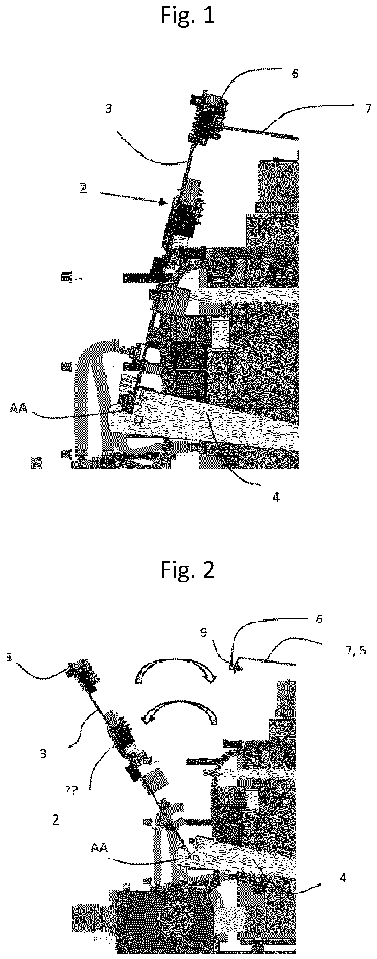

Selon l'invention, afin de faciliter les opérations de montage et d'entretien et/ou maintenance de la carte électronique 3 au sein du ventilateur 1, la carte électronique 3 est montée pivotante, autour d'un axe AA, sur une structure-support 4, typiquement une partie du châssis 5, à l'intérieur du ventilateur 1, comme illustré sur Fig. 1 à Fig. 9.

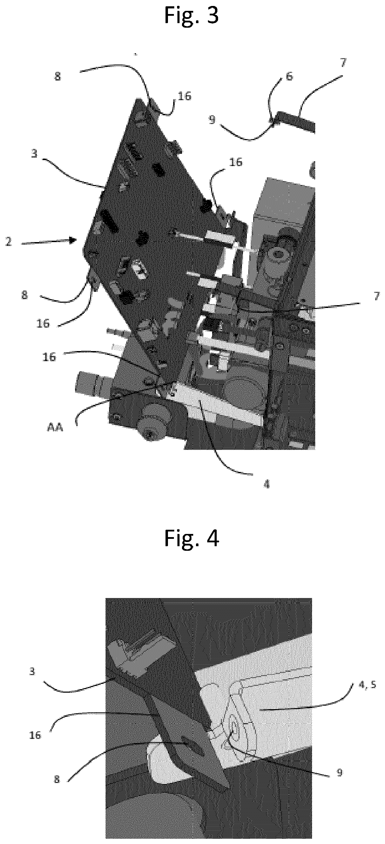

Ainsi, la Fig. 1 représente la carte électronique 3 solidarisée à la structure-support 4 interne du ventilateur 1 et avant son pivotement, c'est-à-dire comme elle se présente pendant le fonctionnement du ventilateur 1, comme illustré en Fig. 6 et Fig. 8 à Fig. 9, alors que Fig. 2 et Fig. 3 représentent la carte électronique 3, montrée en position pivotée selon un angle *β* qui est ici de l'ordre de 45°, c'est-à-dire comme elle se présenter lorsque le capot 10B de la carcasse 10 a été retiré et la carte 3 désolidarisée de la structure-support 4 interne du ventilateur 1, telle châssis 5, comme illustré en Fig. 7.

L'angle de pivotement *β* de la carte électronique 3 est inférieur à 150°, en général inférieur à 120°, typiquement compris entre 20° et 90°, par exemple de l'ordre de 30° à 60°.

Pour faciliter la maintenance, la carte électronique 3 est maintenue par la structure-support 4, typiquement une partie du châssis 5, même lorsqu'elle est pivotée et repose simplement sur celle-ci, dans une structure en « berceau », c'est-à-dire qu'elle n'est pas/plus bloquée par des vis (car elles ont été retirées), comme illustré en Fig. 3 et Fig. 4.

D'une façon générale, la carte électronique 3 comprend une plaque isolante sur laquelle sont montés des composants électroniques, en particulier un ou plusieurs microprocesseurs, un ou des capteurs de pression, des embases de connexion pour raccorder tous les câbles, des fusibles, un avertisseur type « buzzer » ou autres.

Grâce à ce système de montage à pivotement, il n'est plus nécessaire de démonter totalement la carte 3 lors des opérations de câblage ou de maintenance, donc cela limite ses manipulations et les risques de détérioration liés.

Lorsque la carte électronique 3 est solidarisée, c'est-à-dire maintenue immobile dans le ventilateur 1, comme illustré en Fig. 1 et Fig. 6, par exemple pendant son fonctionnement, elle est maintenue immobile par des moyens de maintien 6-9 de préférence par vissage.

Avantageusement, comme montré en Fig. 4, les moyens de maintien 6-9 comprennent ici des vis 6 ou analogues traversant des orifices 8 aménagés sur des petites expansions ou pattes de fixation 16 situées au niveau des angles de la carte électronique 3, qui est ici de forme rectangulaire, et elles-mêmes 16 solidarisées à la carte 3, comme illustré en Fig. 3 et Fig. 4. Les vis 6 viennent se loger/se visser dans des logements taraudés 9 agencés sur la structure-support 4, typiquement une partie du châssis 5, par exemple deux bras de maintien 7 agencés en parallèle, faisant partie du châssis 5. Alternativement, les orifices 8 pourraient être aménagés directement au travers de la carte 3.

Lorsque la carte électronique 3 est en position non-pivotée, comme sur Fig. 1 et Fig. 6 et Fig. 7 à Fig. 9, les petites expansions ou pattes 16 forment des butées venant prendre appui contre la structure-support 4, typiquement le châssis 5. Elle est alors agencée en position verticale ou quasi-verticale.

Sur Fig. 5, on voit aussi que le ventilateur médical 1 comprend par ailleurs :
- une connexion de valve expiratoire 20 pour y raccorder fluidiquement une valve expiratoire, telle la Valve Monnal'EVA^{™}, servant à mesurer le débit de gaze expiré par le patient et rejeté à l'atmosphère,
- un bouton d'éjection de valve expiratoire 21 servant à désolidariser la valve du ventilateur 1, par exemple lors de sa maintenance ou autre, ;
- un connecteur de raccordement d'un dispositif de nébulisation 22 pour y raccorder fluidiquement un dispositif de nébulisation servant à apporter un médicament à nébuliser qui est mélangé au flux gazeux respiratoire au sein du ventilateur 1,
- un connecteur de raccordement de sonde 23 pour y raccorder fluidiquement une sonde oesophagienne permettant de mesure la pression interne à partir d'une telle sonde,
- un connecteur de circuit patient 24 pour y raccorder le circuit patient servant à acheminer les flux gazeux, notamment vers le patient.
- un logement à sonde FiO₂ 25 et son couvercle d'obturation pour y ranger une sonde de mesure du taux de O₂ sanguin du patient.

Par ailleurs, sur Fig. 9, on peut voir que le ventilateur 1 peut comprendre aussi d'autres éléments, notamment des connecteurs 33-36 servant à différents raccordements de type prise USB double, connecteur HDMI, connecteurs RS235 SUB D5 et RJ45, ou autres, un haut-parleur 38, une sonde de température 43, un bloc inspiratoire 42 comprenant les raccordements du circuit patient, de la sortie expiratoire, de la sonde FiO₂, de la sonde de température, du raccord de nébulisation, du raccord de la sonde oesophagiale, des piquages de mesure de pression... un bloc central 41 comprenant les électrovannes, l'admission d'O₂, le détendeur de nébulisation et le capteur de pression O₂...., des tubulures 44 reliant les piquages de mesure de pression vers les capteurs de pression embarqués sur la carte électronique, ou d'autres éléments.

D'une façon générale, le ventilateur médical de l'invention équipé d'une carte électronique montée pivotante est particulièrement bien adaptée à une utilisation en milieu hospitalier.

## Revendications

1. Ventilateur médical (1) comprenant une carcasse externe (10) et des moyens de pilotage (2) comprenant au moins une carte électronique (3), la carcasse comprenant une embase (10A) et un capot (10B) fixé de manière détachable à l'embase (10A), ledit capot (10B) pouvant être retiré pour donner accès à l'intérieur du ventilateur (1),
**caractérisée en ce que** :
- il comprend en outre un écran d'affichage (11) porté par un bras-support (12) surmontant la carcasse (10) du ventilateur (1), et
- ladite carte électronique (3) est montée pivotante (axe AA) sur une structure-support (4) agencée à l'intérieur de la carcasse externe (10) du ventilateur (1).

2. Ventilateur selon la revendication 1, **caractérisé en ce que** la structure-support (4) comprend un châssis (5), de préférence le châssis (5) porte tout ou partie de la carcasse externe (10) du ventilateur (1).

3. Ventilateur selon la revendication 1, **caractérisé en ce que** l'angle de pivotement de la carte électronique (3) est inférieur à 150°, de préférence inférieur à 120°.

4. Ventilateur selon la revendication 1, **caractérisé en ce que** ladite carte électronique (3) comprend un ou plusieurs microprocesseurs.

5. Ventilateur selon l'une des revendications 1 ou 4, **caractérisé en ce que** ladite carte électronique (3) est maintenue immobile par des moyens de maintien (6-9), de préférence des moyens de maintien par vissage.

6. Ventilateur selon la revendication 2, **caractérisé en ce qu'**il comprend en outre une soufflante motorisée (31) portée par le châssis (5).

7. Ventilateur selon l'une des revendications 1, 3 ou 5, **caractérisé en ce que** ladite au moins une carte électronique (3) est agencée en position verticale ou quasi-verticale dans le ventilateur (1).

8. Ventilateur selon les revendications 1 et 6, **caractérisé en ce que** ladite au moins une carte électronique (3) est configurée pour piloter la soufflante motorisée (31) et/ou pour contrôler l'affichage sur l'écran d'affichage (11).

9. Ventilateur selon la revendication 1, **caractérisé en ce que** l'écran d'affichage (11) est orientable selon plusieurs axes par rapport au bras-support (12), de préférence au moins 2 axes perpendiculaires (X, Y).

10. Ventilateur selon la revendication 2, **caractérisé en ce que** le bras-support (12) est fixé au châssis (5).

11. Ventilateur selon l'une des revendications 1, 8 ou 9, **caractérisé en ce qu'**un carter protecteur (11a) est agencé autour de l'écran d'affichage (11).

12. Ventilateur selon l'une des revendications 1, 8, 9 ou 11, **caractérisé en ce que** l'écran d'affichage (11) comprend une ou des poignées de manipulation (14) permettant à un utilisateur de manipuler et orienter l'écran d'affichage (11).

13. Ventilateur selon la revendication 11, **caractérisé en ce que** le carter protecteur (11a) délimite un volume interne situé à l'arrière de l'écran d'affichage (11) et contenant les éléments ou composants électroniques servant à faire fonctionner l'écran d'affichage, en particulier une seconde carte électronique.

14. Ventilateur selon la revendication 3, **caractérisé en ce que** l'angle de pivotement de la carte électronique (3) est compris entre 20° et 90°.

15. Ventilateur selon la revendication 6, **caractérisé en ce qu'**il comprend en outre un circuit de gaz relié fluidiquement à la soufflante (31) de manière à acheminer le gaz fourni par ladite soufflante (31).

## Patentansprüche

1. Medizinisches Beatmungsgerät (1), welches ein äußeres Gehäuse (10) und mindestens eine Elektronikkarte (3) umfassende Steuerungsmittel (2) umfasst, wobei das Gehäuse ein Basisteil (10A) und eine lösbar am Basisteil (10A) befestigte Haube (10B) umfasst, wobei die Haube (10B) abgenommen werden kann, um einen Zugang zum Inneren des Beatmungsgerätes (1) zu ermöglichen,
**dadurch gekennzeichnet, dass**:
- es außerdem einen Anzeigebildschirm (11) umfasst, der von einem Tragarm (12) getragen wird, der das Gehäuse (10) des Beatmungsgerätes (1) überragt, und
- die Elektronikkarte (3) schwenkbar (Achse AA) auf einer Tragstruktur (4) angebracht ist, die im Inneren des äußeren Gehäuses (10) des Beatmungsgerätes (1) angeordnet ist.

2. Beatmungsgerät nach Anspruch 1, **dadurch gekennzeichnet, dass** die Tragstruktur (4) einen Rahmen (5) umfasst, wobei der Rahmen (5) vorzugsweise das gesamte äußere Gehäuse (10) des Beatmungsgerätes (1) oder einen Teil davon trägt.

3. Beatmungsgerät nach Anspruch 1, **dadurch gekennzeichnet, dass** der Schwenkwinkel der Elektronikkarte (3) kleiner als 150° ist, vorzugsweise kleiner als 120°.

4. Beatmungsgerät nach Anspruch 1, **dadurch gekennzeichnet, dass** die Elektronikkarte (3) einen oder mehrere Mikroprozessoren umfasst.

5. Beatmungsgerät nach einem der Ansprüche 1 oder 4, **dadurch gekennzeichnet, dass** die Elektronikkarte (3) von Haltemitteln (6-9) unbeweglich gehalten wird, vorzugsweise von Mitteln zum Halten durch Verschraubung.

6. Beatmungsgerät nach Anspruch 2, **dadurch gekennzeichnet, dass** es außerdem ein motorisiertes Gebläse (31) umfasst, das vom Rahmen (5) getragen wird.

7. Beatmungsgerät nach einem der Ansprüche 1, 3 oder 5, **dadurch gekennzeichnet, dass** die mindestens eine Elektronikkarte (3) in einer vertikalen oder nahezu vertikalen Position im Beatmungsgerät (1) angeordnet ist.

8. Beatmungsgerät nach den Ansprüchen 1 und 6, **dadurch gekennzeichnet, dass** die mindestens eine Elektronikkarte (3) dafür ausgelegt ist, das motorisierte Gebläse (31) zu steuern und/oder die Anzeige auf dem Anzeigebildschirm (11) zu steuern.

9. Beatmungsgerät nach Anspruch 1, **dadurch gekennzeichnet, dass** der Anzeigebildschirm (11) in Bezug auf den Tragarm (12) entlang mehrerer Achsen ausrichtbar ist, vorzugsweise entlang von mindestens 2 zueinander senkrechten Achsen (X, Y).

10. Beatmungsgerät nach Anspruch 2, **dadurch gekennzeichnet, dass** der Tragarm (12) am Rahmen (5) befestigt ist.

11. Beatmungsgerät nach einem der Ansprüche 1, 8 oder 9, **dadurch gekennzeichnet, dass** um den Anzeigebildschirm (11) herum ein Schutzgehäuse (11a) angeordnet ist.

12. Beatmungsgerät nach einem der Ansprüche 1, 8, 9 oder 11, **dadurch gekennzeichnet, dass** der Anzeigebildschirm (11) einen oder mehrere Handhabungsgriffe (14) umfasst, die es einem Benutzer ermöglichen, den Anzeigebildschirm (11) zu handhaben und auszurichten.

13. Beatmungsgerät nach Anspruch 11, **dadurch gekennzeichnet, dass** das Schutzgehäuse (11a) ein Innenvolumen begrenzt, dass sich hinter dem Anzeigebildschirm (11) befindet und die elektronischen Elemente oder Komponenten enthält, die dazu dienen, den Betrieb des Anzeigebildschirms zu ermöglichen, insbesondere eine zweite Elektronikkarte.

14. Beatmungsgerät nach Anspruch 3, **dadurch gekennzeichnet, dass** der Schwenkwinkel der Elektronikkarte (3) zwischen 20° und 90° liegt.

15. Beatmungsgerät nach Anspruch 6, **dadurch gekennzeichnet, dass** es außerdem einen Gaskreislauf umfasst, der mit dem Gebläse (31) in Fluidverbindung steht, um das von dem Gebläse (31) gelieferte Gas zu transportieren.

## Claims

1. Medical ventilator (1) comprising an outer casing (10) and control means (2) comprising at least one electronic card (3), the casing comprising a base (10A) and a cover (10B) fastened removably to the base (10A), said cover (10B) being removable to provide access to the inside of the ventilator (1),
**characterized in that**:
- it also comprises a display screen (11) carried by a support arm (12) on top of the casing (10) of the ventilator (1), and
- said electronic card (3) is mounted pivotingly (axis AA) on a support structure (4) arranged inside the outer casing (10) of the ventilator (1).

2. Ventilator according to Claim 1, **characterized in that** the support structure (4) comprises a chassis (5), and the chassis (5) preferably bears some or all of the outer casing (10) of the ventilator (1).

3. Ventilator according to Claim 1, **characterized in that** the pivot angle of the electronic card (3) is less than 150°, preferably less than 120°.

4. Ventilator according to Claim 1, **characterized in that** said electronic card (3) comprises one or more microprocessors.

5. Ventilator according to either of Claims 1 and 4, **characterized in that** said electronic card (3) is held immobile by retaining means (6-9), preferably screw retaining means.

6. Ventilator according to Claim 2, **characterized in that** it further comprises a motorized blower (31) carried by the chassis (5).

7. Ventilator according to one of Claims 1, 3 and 5, **characterized in that** said at least one electronic card (3) is arranged in a vertical or near-vertical position in the ventilator (1).

8. Ventilator according to Claims 1 and 6, **characterized in that** said at least one electronic card (3) is configured to control the motorized blower (31) and/or to control the display on the display screen (11).

9. Ventilator according to Claim 1, **characterized in that** the display screen (11) can be oriented about several axes in relation to the support arm (12), preferably at least two perpendicular axes (X, Y).

10. Ventilator according to Claim 2, **characterized in that** the support arm (12) is fastened to the chassis (5).

11. Ventilator according to one of Claims 1, 8 and 9, **characterized in that** a protective housing (11a) is arranged about the display screen (11).

12. Ventilator according to one of Claims 1, 8, 9 and 11, **characterized in that** the display screen (11) comprises one or more handling handles (14) enabling a user to handle and orient the display screen (11).

13. Ventilator according to Claim 11, **characterized in that** the protective housing (11a) delimits an internal volume behind the display screen (11) that contains electronic components or elements used to operate the display screen, in particular a second electronic card.

14. Ventilator according to Claim 3, **characterized in that** the pivot angle of the electronic card (3) is between 20° and 90°.

15. Ventilator according to Claim 6, **characterized in that** it also comprises a gas circuit fluidically connected to the blower (31) to convey the gas supplied by said blower (31).
